(19) Europäisches Patentamt
European Patent Office
Office européen des brevets

(11) **EP 2 306 653 A1**

(12) **EUROPEAN PATENT APPLICATION**
published in accordance with Art. 153(4) EPC

(43) Date of publication:
**06.04.2011 Bulletin 2011/14**

(51) Int Cl.:
***H03M 13/19*** *(2006.01)*

(21) Application number: **09773143.4**

(22) Date of filing: **26.06.2009**

(86) International application number:
**PCT/JP2009/002955**

(87) International publication number:
**WO 2010/001565 (07.01.2010 Gazette 2010/01)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **04.07.2008 JP 2008175847**

(71) Applicant: **Mitsubishi Electric Corporation Tokyo 100-8310 (JP)**

(72) Inventors:
• **MATSUMOTO, Wataru Tokyo 100-8310 (JP)**
• **YOSHIDA, Hideo Tokyo 100-8310 (JP)**

(74) Representative: **Pfenning, Meinig & Partner GbR Patent- und Rechtsanwälte Theresienhöhe 13 80339 München (DE)**

(54) **CHECK MATRIX CREATION DEVICE, CHECK MATRIX CREATION METHOD, CHECK MATRIX CREATION PROGRAM, TRANSMISSION DEVICE, RECEPTION DEVICE, AND COMMUNICATION SYSTEM**

(57) A check matrix creation device includes a circulant permutation matrix setting unit 12 for preparing a plurality of circulant permutation matrices each having an inner diameter of six or larger, and a quasi-cyclic matrix creation unit 13 for arranging the plurality of circulant permutation matrices prepared by the circulant permutation matrix setting unit 12 both in a row direction and in a column direction to create a quasi-cyclic matrix.

FIG.1

**Description**

Field of the Invention

The present invention relates to an encoding technology for use in digital communications. More particularly, it relates to a check matrix creation device for, a check matrix creation method of and a check matrix creation program for creating a parity check matrix for an LDPC (Low-Density Parity Check) code, a transmitter that encodes predetermined information bits by using a parity check matrix for LDPC code and transmits the encoded predetermined information bits, a receiver that decodes predetermined information bits by using a parity check matrix for an LDPC code, and a communication system consisting of the above-mentioned transmitter and the above-mentioned receiver.

Background of the Invention

Hereafter, a conventional communication system which uses an LDPC code as an encoding method will be explained.

A case in which a quasi-cyclic (QC: Quasi-Cyclic) code is used as an example of an LDPC code will be explained (for example, refer to nonpatent reference 1).

First, encoding and decoding processing in the conventional communication system which uses an LDPC code as an encoding method will be explained briefly.

An LDPC encoder is mounted in a transmitter which is a communication device on a transmit side of the communication system, and creates a parity check matrix H by using a conventional method which will be mentioned later.

The LDPC encoder also creates a generator matrix G of K rows and N columns (K: an information length, N: a codeword length), for example.

When the parity check matrix for LDPC is a matrix of M rows and N columns, the generator matrix G satisfies $GH^T=0$ (T shows that the matrix is a transposed matrix).

When receiving a message $(m_1, m_2, ..., m_K)$ having an information length of K as information bits after creating the parity check matrix H and the generator matrix G, the LDPC encoder uses the message $(m_1, m_2, ..., m_K)$ and the generator matrix G to create a codeword C, as shown in the following equation (1).

$$C = (m_1, \ m_2, \ ..., \ m_K) \, G$$
$$= (c_1, c_2, ..., c_N) \hspace{4cm} (1)$$

where the following equation: $H \, (c_1, c_2, ..., c_N)^T = 0$ is satisfied.

When the LDPC encoder creates the codeword C, the modulator of the transmitter performs digital modulation according to a modulation method, such as BPSK (Binary Phase Shift Keying), QPSK (Quadrature Phase Shift Keying), or multiple-value QAM (Quadrature Amplitude Modulation), for example, and transmits a modulated signal $x = (x_1, x_2, ..., x_N)$ of the codeword C to a receiver.

When the transmitter transmits the modulated signal $x = (x_1, x_2, ..., x_N)$, the demodulator of the receiver which is a communication device on a receive side of the communication system receives a corresponding modulated signal $y = (y_1, y_2, ..., y_N)$ which has been propagated thereto via a communication channel.

When receiving the modulated signal $y = (y_1, y_2, ..., y_N)$, the demodulator of the receiver performs digital demodulation corresponding to the modulation method, such as BPSK, QPSK, or multiple-value QAM, on the modulated signal.

An LDPC decoder of the receiver performs iterative decoding according to a "sum-product algorithm" on the demodulated result obtained by the demodulator, and, as the decoded result, outputs a message corresponding to the original message $m_1, m_2, ..., $ and $m_K$.

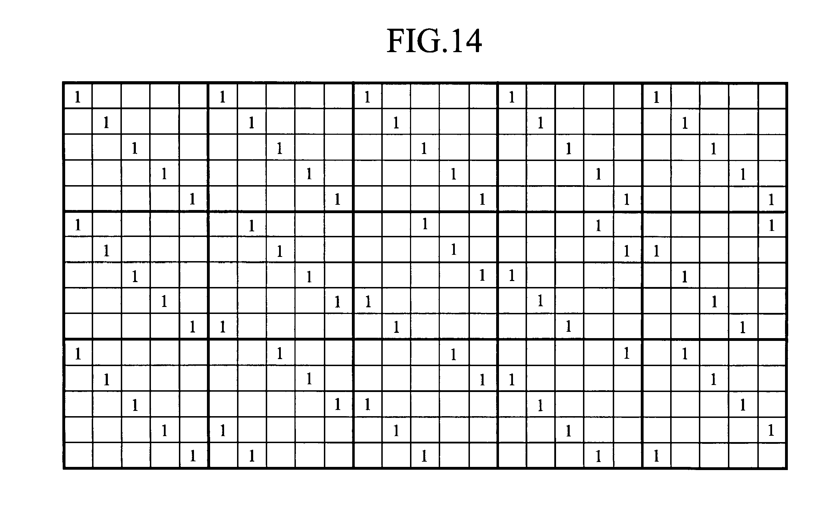

Hereafter, a parity check matrix for an LDPC code in the conventional communication system will be explained. For example, nonpatent reference 1 shown below discloses, as a parity check matrix for an LDPC code, the parity check matrix of a QC code as shown in Fig. 14.

The parity check matrix of a QC code shown in Fig. 14 is formed of circulant permutation matrices (p=5) of five rows and five columns which are arranged both in a longitudinal direction (J=3) and in a lateral direction (L=5).

In general, the parity-check matrix $H_{QC}$ of a (J, L) QC code of M (=pJ) rows and N (=pL) columns can be defined as shown in the following equation (2).

In this equation, p is a non-zero integer.

Furthermore, L shows the number of circulant permutation matrices arranged in the lateral direction (column direction) in the parity-check matrix $H_{QC}$, and J shows the number of circulant permutation matrices arranged in the longitudinal direction (row direction) in the parity-check matrix $H_{QC}$.

$$I(0) = \begin{bmatrix} I(p_{0,0}) & I(p_{0,1}) & \cdots & I(p_{0,L-1}) \\ I(p_{1,0}) & I(p_{1,1}) & \cdots & I(p_{1,L-1}) \\ \vdots & \vdots & \ddots & \vdots \\ I(p_{J-1,0}) & I(p_{J-1,1}) & \cdots & I(p_{J-1,L-1}) \end{bmatrix} \quad \text{Example:} \quad P = 5, I(0) = \begin{bmatrix} 1 & 0 & 0 & 0 & 0 \\ 0 & 1 & 0 & 0 & 0 \\ 0 & 0 & 1 & 0 & 0 \\ 0 & 0 & 0 & 1 & 0 \\ 0 & 0 & 0 & 0 & 1 \end{bmatrix}$$

$$(2)$$

where for 0<=j<=J-1 and 0<=l<=L-1, I $(p_{j,1})$ is a circulant permutation matrix in which any component whose row number is "r" (0<=r<=p-1) and whose column number is "(r+$p_{j,1}$) mod p" is "1", and any other components are all "0".

Furthermore, when an LDPC code is designed, because there is a high possibility that existence of many loops having a short length generally causes degradation in the performance, it is necessary to increase the inner diameter to reduce the number of loops having a short length (e.g., length-4 loops, length-6 loops, and so on).

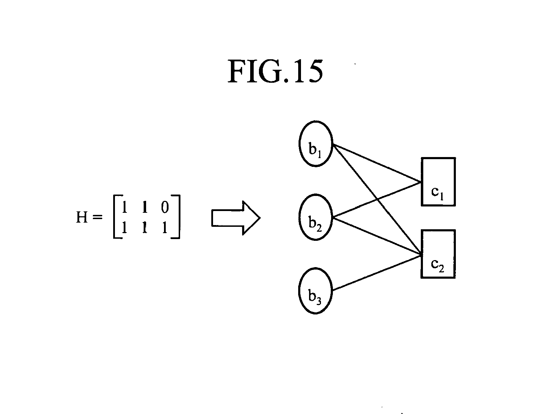

Fig. 15 is an explanatory drawing showing an example of a parity-check matrix in the form of a Tanner graph. In Fig. 15, in a parity-check matrix H of M rows and N columns having two elements { 0, 1 } , a node corresponding to each column is represented by a bit node $b_n$ (1<=n<=N) (in the figure, O shows each bit node), and a node corresponding to each row is represented by a check node $c_m$ (1<=m<=M) (in the figure, □ shows each check node). A bipartite graph in which a bit node and a check node corresponding to each of all the intersections of rows and columns at which "1" exists is connected by a branch is called a Tanner graph.

Hereafter, the meaning of a loop mentioned above will be explained. As shown in Fig. 15, a "loop" shows a closed path starting from a specific node (corresponding to ○ or □ in the figure), and ending at this node. Furthermore, the "inner diameter" means the length of the shortest loop, and "the length of a loop" is represented by the number of branches which construct the closed path. Loops are simply expressed as length-4 loops, length-6 loops, length-8 loops, and so on according to their lengths.

Furthermore, in the following nonpatent reference 1, the range of inner diameters g in the parity-check matrix $H_{QC}$ of a (J,L) QC-LDPC code is defined to be equal to "4<=g<=12 (g is an even number) ". However, it is easy to avoid g=4 and, in many cases, the inner diameter range is g>=6.

Related art document

Nonpatent reference

Nonpatent reference 1: M. Fossorier, "Quai-Cyclic Low-Density Parity-Check Codes From Circulant Permutation Matrices", IEEE Trans. Inform. Theory, Vo1.50, No.8 (2004) pp. 1788-1793.

Summary of the Invention

Because the conventional communication systems are constructed as above, a parity-check matrix $H_{QC}$ whose range of inner diameters g is "4<=g<=12 (g is an even number) is used. However, a design method of designing an LDPC code under the conditions that g>=6, g>=8, g>=10, g>=12, or ... is satisfied has not been shown concretely. A problem is therefore that it is necessary to design an LDPC code by mainly using a computer search and therefore it takes much time to design an LDPC code.

Another problem is that because such a method lacks in extendibility and also lacks in the regularity among circulant permutation matrices, the degree of complexity increases at the time of implementation.

It has not been proved that the results obtained through a computer search are optimal.

The present invention is made in order to solve the above-mentioned problems, and it is therefore an object of the present invention to provide a check matrix creation device, a check matrix creation method, and a check matrix creation program capable of creating a parity-check matrix for an irregular LDPC code which has a better performance than that created using a method of configuring a check matrix through a computer search, and which has a regular configuration and can support a wide range of coding rates.

It is another object of the present invention to provide a transmitter and a communication system which have a good performance and which can encode predetermined information bits by using a parity-check matrix having a regular configuration, and transmit them.

It is a further object of the present invention to provide a receiver and a communication system which have a good performance and which can decode predetermined information bits by using a parity-check matrix having a regular configuration.

In accordance with the present invention, there is provided a check matrix creation device including: a circulant permutation matrix setting means for preparing a plurality of circulant permutation matrices; and a quasi-cyclic matrix creation means for arranging the plurality of circulant permutation matrices prepared by the circulant permutation matrix setting means both in a row direction and in a column direction to create a quasi-cyclic matrix.

Because the check matrix creation device in accordance with the present invention is constructed in such a way as to include the circulant permutation matrix setting means for preparing a plurality of circulant permutation matrices, and the quasi-cyclic matrix creation means for arranging the plurality of circulant permutation matrices prepared by the circulant permutation matrix setting means both in the row direction and in the column direction to create a quasi-cyclic matrix, there is provided an advantage of being able to create a parity-check matrix for an irregular LDPC code which has a better performance than that created using a method of forming a check matrix through a computer search, and which has a regular configuration and can support a wide range of coding rates.

Brief Description of the Figures

[Fig. 1] Fig. 1 is a block diagram showing a communication system in accordance with Embodiment 1 of the present invention;

[Fig. 2] Fig. 2 is a flow chart showing processes respectively carried out by check matrix creation devices 11 and 21;

[Fig. 3] Fig. 3 is an explanatory drawing showing a graph G of the check matrix of an LDPC code in QC;

[Fig. 4] Fig. 4 is an explanatory drawing showing the graph G which is shown using $V_l = \{v_{l,0}, v_{l,1}, ..., v_{l,p-1}\}$ for $0 \leq l \leq L-1$, and $C_j = \{c_{j,0}, c_{j,1}, ..., c_{j,p-1}\}$ for $0 \leq j \leq J-1$;

[Fig. 5] Fig. 5 is an explanatory drawing showing a graph $G_0^g$ which is a bipartite graph;

[Fig. 6] Fig. 6 is an explanatory drawing showing a subgraph of nodes connected to $V_0$;

[Fig. 7] Fig. 7 is an explanatory drawing showing a subgraph in which $V_0$ is divided into $V_{0\_0}$, $V_{0\_1}$, and $V_{0\_2}$;

[Fig. 8] Fig. 8 is an explanatory drawing showing a state in which two graphs $\underline{G}_0^g$ and $\underline{G}_1^g$ are connected to each other via p branches;

[Fig. 9] Fig. 9 is an explanatory drawing showing a state in which two graphs $\underline{G}_0^g$ and $\underline{G}_1^g$ are connected to each other via 2*p branches;

[Fig. 10] Fig. 10 is an explanatory drawing showing conversion of a graph $G_0^{10}$ into a graph $\underline{G}_0^{10}$;

[Fig. 11] Fig. 11 is an explanatory drawing showing a graph using a check matrix Who,1;

[Fig. 12] Fig. 12 is a block diagram showing a communication system in accordance with Embodiment 2 of the present invention; [Fig. 13] Fig. 13 is a block diagram showing a communication system in accordance with Embodiment 3 of the present invention; [Fig. 14] Fig. 14 is an explanatory drawing showing a parity-check matrix for LDPC codes disclosed by nonpatent reference 1; and

[Fig. 15] Fig. 15 is an explanatory drawing showing an example of the parity-check matrix in the form of a Tanner graph. Embodiments of the Invention

Hereafter, in order to explain this invention in greater detail, the preferred embodiments of the present invention will be described with reference to the accompanying drawings. Embodiment 1.

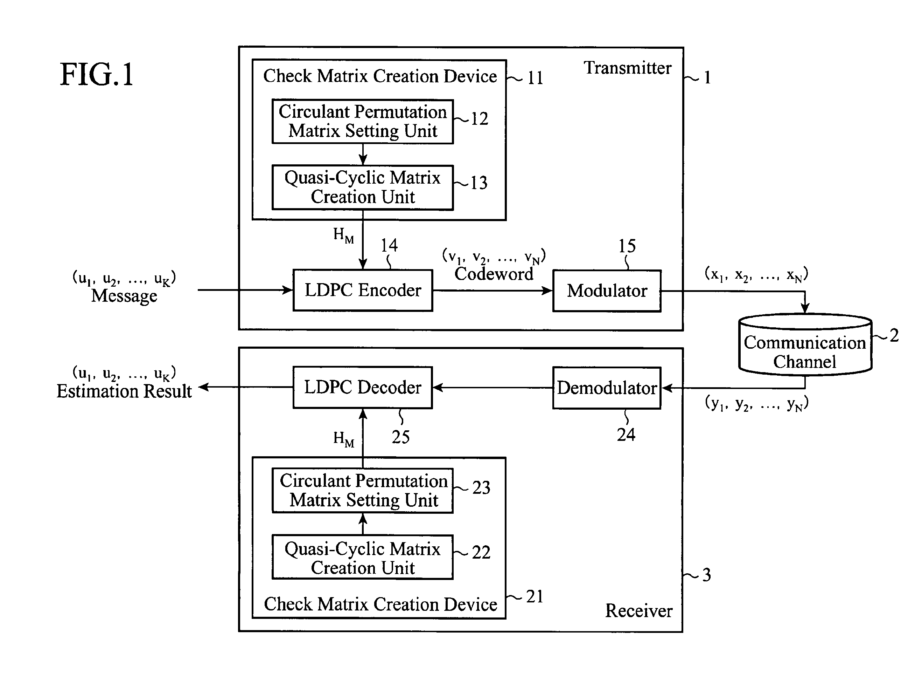

Fig. 1 is a block diagram showing a communication system in accordance with Embodiment 1 of the present invention. In the figure, a transmitter 1 is a communication device on a transmit side of the communication system, and carries out a process of creating a codeword $(v_1, v_2, ..., v_N)$ from both a message $(u_1, u_2, ..., u_K)$ having an information length of K which is predetermined information bits, and a parity-check matrix $H_M$ for an LDPC code, modulating the codeword $(v_1, v_2, ..., v_N)$, and transmitting a modulated signal $(x_1, x_2, ..., x_N)$ of the codeword via a communication channel 2.

The receiver 3 is a communication device on a receive side of the communication system, and, when receiving a modulated signal $(y_1, y_2, ..., y_N)$ of a codeword transmitted from the transmitter 1, carries out a process of demodulating the modulated signal $(y_1, y_2, ..., y_N)$, and decodes this demodulated signal to generate a message $(u_1, u_2, ..., u_K)$ having an information length of K.

A check matrix creation device 11 of the transmitter 1 carries out a process of preparing a plurality of circulant permutation matrices each having an inner diameter g of six or larger, and arranging the plurality of circulant permutation matrices both in a row direction and in a column direction to create a quasi-cyclic matrix which is a parity-check matrix $H_M$ for an LDPC code.

A circulant permutation matrix setting unit 12 of the check matrix creation device 11 carries out the process of preparing the plurality of circulant permutation matrices each having an inner diameter g of six or larger. The circulant permutation matrix setting unit 12 constructs a circulant permutation matrix setting means.

A quasi-cyclic matrix creation unit 13 of the check matrix creation device 11 carries out the process of arranging the plurality of circulant permutation matrices prepared by the circulant permutation matrix setting unit 12 both in the row direction and in the column direction to create a quasi-cyclic matrix which is a parity-check matrix $H_M$ for an LDPC code. The quasi-cyclic matrix creation unit 13 constructs a quasi-cyclic matrix creation means.

An LDPC encoder 14 of the transmitter 1 carries out a process of creating a codeword $(v_1, v_2, ..., v_N)$ from both a message $(u_1, u_2, ..., u_K)$ having an information length of K, and the parity-check matrix $H_M$ for an LDPC code created by the check matrix creation device 11. The LDPC encoder 14 constructs a codeword creation means.

A modulator 15 of the transmitter 1 carries out a process of modulating the codeword $(v_1, v_2, ..., v_N)$ created by the LDPC encoder 14, and transmitting a modulated signal $(x_1, x_2, ..., x_N)$ of the codeword to the receiver 3 via the communication channel 2. The modulator 15 constructs a transmitting means.

The check matrix creation device 11 of the transmitter 1 carries out the process of preparing a plurality of circulant permutation matrices each having an inner diameter g of six or larger, and arranging the plurality of circulant permutation matrices both in the row direction and in the column direction to create a quasi-cyclic matrix which is a parity-check matrix $H_M$ for an LDPC code.

The circulant permutation matrix setting unit 12 of the check matrix creation device 11 carries out the process of preparing a plurality of circulant permutation matrices each having an inner diameter g of six or larger. The circulant permutation matrix setting unit 12 constructs the circulant permutation matrix setting means.

The quasi-cyclic matrix creation unit 13 of the check matrix creation device 11 carries out the process of arranging the plurality of circulant permutation matrices prepared by the circulant permutation matrix setting unit 12 both in the row direction and in the column direction to create a quasi-cyclic matrix which is a parity-check matrix $H_M$ for an LDPC code. The quasi-cyclic matrix creation unit 13 constructs the quasi-cyclic matrix creation means.

In this Embodiment 1, the check matrix creation device 11 which is comprised of the circulant permutation matrix setting unit 12 and the quasi-cyclic matrix creation unit 13 is shown. As an alternative, the check matrix creation device 11 can be constructed of a computer, and, in this case, a check matrix creation program in which the processes of the circulant permutation matrix setting unit 12 and the quasi-cyclic matrix creation unit 13 are described can be stored in a memory of the computer and the CPU of the computer can be made to execute the check matrix creation program.

When the receiver 3 receives a modulated signal $(y_1, y_2, ..., y_N)$ of a codeword transmitted from the transmitter 1, a demodulator 24 of the receiver 3 carries out a process of demodulating the modulated signal $(y_1, y_2, ..., y_N)$. The demodulator 24 constructs a receiving means.

An LDPC decoder 25 of the receiver 3 carries out a process of performing iterative decoding according to a known decoding algorithm on the demodulated result obtained by the demodulator 24 by using a parity-check matrix $H_M$ created by a check matrix creation device 21, and outputting a message corresponding to the original message $(u_1, u_2, ..., u_K)$ as the decoded result. The LDPC decoder 25 constructs a decoding means.

In Fig. 1, the example in which the check matrix creation device 11 is disposed separately from the LDPC encoder 14 is shown, although the LDPC encoder 14 can include the check matrix creation device 11.

As an alternative, the check matrix creation device 11 can be disposed outside the transmitter 1. In this case, the parity-check matrix $H_M$ for an LDPC code created by the check matrix creation device 11 can be stored in an internal memory of the transmitter 1, or the transmitter can receive the parity-check matrix $H_M$ from the check matrix creation device 11.

Furthermore, in Fig. 1, the example in which the check matrix creation device 21 is disposed separately from the LDPC decoder 25 is shown, although the LDPC decoder 25 can include the check matrix creation device 21.

As an alternative, the check matrix creation device 21 can be disposed outside the receiver 3. In this case, the parity-check matrix $H_M$ for an LDPC code created by the check matrix creation device 21 can be stored in an internal memory of the receiver 3, and the receiver can receive the parity-check matrix $H_M$ from the check matrix creation device 21.

Next, the operation of the communication system will be explained.

First, encoding and decoding processing carried out by the communication system of Fig. 1 which uses an LDPC code as an encoding method will be explained briefly.

The check matrix creation device 11 of the transmitter 1 prepares a plurality of circulant permutation matrices each having an inner diameter g of six or larger, and arranges the plurality of circulant permutation matrices both in the row direction and in the column direction to create a quasi-cyclic matrix which is a parity-check matrix $H_M$ for an LDPC code. More specifically, the circulant permutation matrix setting unit 12 of the check matrix creation device 11 prepares a plurality of circulant permutation matrices each having an inner diameter g of six or larger in advance, although will be mentioned below in detail.

After the circulant permutation matrix setting unit 12 prepares the plurality of circulant permutation matrices, the quasi-cyclic matrix creation unit 13 of the check matrix creation device 11 arranges the plurality of circulant permutation matrices both in the row direction and in the column direction to create a quasi-cyclic matrix which is a parity-check matrix $H_M$

for an LDPC code, although will be mentioned below in detail.

After the check matrix creation device 11 creates the parity-check matrix $H_M$ of M rows and N columns as the parity-check matrix $H_M$ for an LDPC code, when receiving a message $(u_1, u_2, ..., u_K)$ having an information length of K, the LDPC encoder 14 of the transmitter 1 creates a codeword v= $(v_1, v_2, ..., v_N)$ having a length of N from the message $(u_1, u_2, ..., u_K)$ and the parity-check matrix $H_M$, as shown in the following equation (3).

$$v= \{ (v_1, v_2, ..., v_N) \in GF(2) \mid (v_1, v_2, ..., v_N) H_M^T = 0 \} \qquad (3)$$

In this Embodiment 1, the LDPC encoder carries out a process of encoding the information bits without using a generator matrix G (K: an information length, N: a codeword length), unlike in the case of the conventional example. More specifically, when the parity-check matrix $H_M$ has a part having a lower triangular matrix configuration, the LDPC encoder can implement the encoding easily without using a generator matrix G.

For example, when a systematic codeword v is expressed as will be shown below, and a message u= $(u_1, u_2, ..., u_K)$ having an information length of K is provided, the LDPC encoder creates a parity component $p_m = (p_1, p_2, ..., p_M)$ in such a way that "$H*v^T=0$" is satisfied. More specifically, the LDPC encoder creates the parity component $p_m = (p_1, p_2, ..., p_M)$ as shown in the following equation (4).

$$v= (v_1, v_2, ..., v_K, v_{K+1}, v_{K+2}, ..., v_N)$$

$$= (u_1, u_2, ..., u_K, p_1, p_2, ..., p_M)$$

where N=K+M.

$$p_m = \sum_{n=1}^{K+m-1} v_n h_{m,n} \quad , 1 \le m \le M, \; 1 \le n \le N \qquad (4)$$

where $h_{m,n}$ shows a component having a row number m and a column number n in the parity-check matrix $H_M$.

After the LDPC encoder 14 creates the codeword $(v_1, v_2, ..., v_N)$, the modulator 15 of the transmitter 1 performs digital modulation according to a modulation method, such as BPSK, QPSK, or multiple-value QAM, on the codeword $(v_1, v_2, ..., v_N)$, and transmits a modulated signal x=$(x_1, x_2, ..., x_N)$ of the codeword $(v_1, v_2, ..., v_N)$ to the receiver 3 via the communication channel 2.

The check matrix creation device 21 of the receiver 3 prepares a plurality of circulant permutation matrices each having an inner diameter g of six or larger, and arranges the plurality of circulant permutation matrices both in the row direction and in the column direction to create a quasi-cyclic matrix which is a parity-check matrix $H_M$ for an LDPC code in the same way that the check matrix creation device 11 of the transmitter 1 does.

More specifically, the circulant permutation matrix setting unit 22 of the check matrix creation device 21 prepares a plurality of circulant permutation matrices each having an inner diameter g of six or larger in advance.

After the circulant permutation matrix setting unit 22 prepares the plurality of circulant permutation matrices, the quasi-cyclic matrix creation unit 23 of the check matrix creation device 21 arranges the plurality of circulant permutation matrices both in the row direction and in the column direction to create a parity-check matrix $H_M$ for an LDPC code.

When the transmitter 1 transmits the modulated signal x=$(x_1, x_2, ..., x_N)$, the demodulator 24 of the receiver 3 receives the modulated signal y=$(y_1, y_2, ..., y_N)$ which has been propagated thereto via the communication channel 2.

When receiving the modulated signal y=$(y_1, y_2, ..., y_N)$, the demodulator 24 of the receiver 3 carries out digital demodulation corresponding to the modulation method, such as BPSK, QPSK, or multiple-value QAM, on the modulated signal y. The LDPC decoder 25 of the receiver 3 performs iterative decoding according to a known decoding algorithm on the demodulated result obtained by the demodulator 24 by using the parity-check matrix $H_M$ created by the check matrix creation device 21, and outputs a message corresponding to the original message $(u_1, u_2, ..., u_K)$ as the decoded result.

Hereafter, a method of creating a parity-check matrix $H_M$ which each of the check matrix creation devices 11 and 21 uses will be explained concretely.

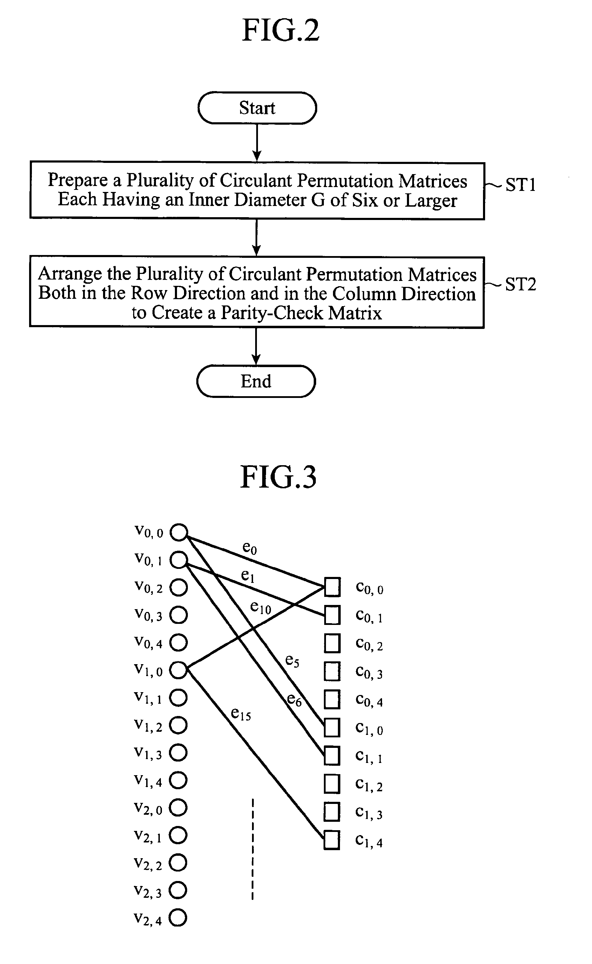

Fig. 2 is a flow chart showing a process carried out by the check matrix creation devices 11 and 21.

[Condition for configuring a new check matrix from a combination of check matrices each having an inner diameter of g]

Hereafter, a (J,L)-regular bipartite graph representing the check matrix of an LDPC code in (J, L) -regular QC is expressed as "G".

The graph G consists of a set of n=L*p bit nodes having a degree of $\lambda$: $\lambda$={ $V_0$, $V_1$, ..., $V_{L-1}$} for $V_l$={ $v_{l,0}$, $v_{l,1}$, ..., $v_{l,p-1}$} and 0<=l<=L-1, and a set of m=J*p check nodes having a degree of $\rho$: $\Gamma$={$C_0$, $C_1$, ..., $C_{J-1}$} for $C_j$={ $c_{j,0}$, $c_{j,1}$, ..., $c_{j,p-1}$} and 0<=j<=J-1.

A set of $N_e$=n*J=m*L branches: $\Xi$={$e_0$, $e_1$, ..., $e_{N-1}$} is included in the graph G.

Furthermore, when the nodes connected to a branch $e_i$ for 0<=i<=$N_e$ are $v_{l,1}$ and $c_{j,0}$, for example, this connection is expressed as ($v_{l,1}$, $c_{j,0}$).

Each branch $e_i$ also has a bit node as a left-hand side vertex, and a check node as a right-hand side vertex.

Bit Node as Left-Hand Side Vertex $v_{l, i/p}$, $l = \lfloor i/(J \cdot p) \rfloor$.

Check Node as Right -Hand Side Vertex $c_{J,((i \bmod p)-p_{j,l}) \bmod p}$, $l = \lfloor i/p \rfloor \bmod J$

For example, in the case of the following check matrix,

$$\begin{bmatrix} I(0) & I(0) & I(0) \\ I(0) & I(1) & I(2) \end{bmatrix} =$$

the graph G of the check matrix of an LDPC code in QC is represented as shown in Fig. 3. However, in Fig. 3, only a part of the branches is shown. From this graph G, an example of the relationship between the branches and the nodes each of which is a vertex can be verified.

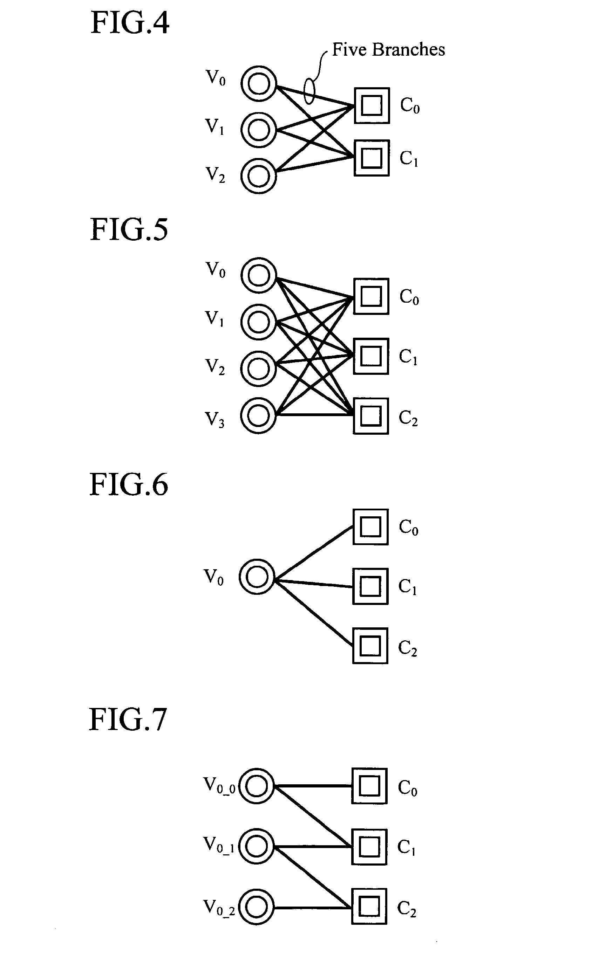

Fig. 4 shows the graph G by using $V_l$={ $v_{l,0}$, $v_{l,1}$, ..., $v_{l,p-1}$} for 0<=l<=L-1, and $C_j$={$c_{j,0}$, $c_{j,1}$, ..., $c_{j,p-1}$} for 0 <=j<=J-1. As shown in Fig. 4, for example, a set $V_1$ of bit nodes is connected to a set $C_0$ of check nodes via I(0), and is also connected to a set $C_1$ of check nodes via I(1).

Hereafter, when the graph G has an inner diameter of g, it is expressed as $G_x^g$, and it is assumed that $G_x^g \neq G_x'^g$ when x≠x'. Furthermore, it is assumed that a graph $G_0^g$ is a bipartite graph as shown in Fig. 5.

At this time, focusing attention on a set $V_0$ of bit nodes of this graph $G_0^g$, all loops formed via $V_0$, and $C_0$, $C_1$ and $C_2$ have inner diameters of g or larger.

For example, as shown in Fig. 6, in the subgraph of nodes connected to $V_0$, all of a loop extending via ($V_0$, $C_0$) and ($V_0$, $C_1$), a loop extending via ($V_0$, $C_0$) and ($V_0$, $C_2$), and a loop extending via ($V_0$, $C_1$) and ($V_0$, $C_2$) have inner diameters of g or larger.

$V_0$ is divided into $V_{0\_0}$, $V_{0\_1}$, and $V_{0-2}$ in this subgraph, as shown in Fig. 7, and branches are newly formed under conditions that no loop is produced in the subgraph comprised of $V_{0-0}$, $V_{0-1}$ and $V_{0-2}$, and $C_0$, $C_1$ and $C_2$,

The whole of this graph obtained after the division is done is expressed as $\underline{G_0}^g$.

For example, it is assumed that $V_1$ is connected to $C_0$ via I(0), is connected to $C_1$ via I(1), and is connected to $C_2$ via I (2) .

Furthermore, it is assumed that after the division is done, $V_{0-0}$ is connected to $C_0$ via I(0) and is also connected to $C_1$ via I(1), $V_{0\_1}$ is connected to $C_1$ via I(1) and is also connected to $C_2$ via I(2), and $V_{0\_2}$ is connected to $C_1$ via I(2).

As a result of this division, because each loop extending via ($V_0$, $C_0$) and ($V_0$, $C_1$) in the graph $G_0^g$, and each loop extending via ($V_{0\_0}$, $C_0$) and ($V_{0\_0}$, $C_1$) in the graph $\underline{G_0}^g$ pass the same I(0) and I(1) respectively, their loop lengths do not change and are equal to or longer than g.

Similarly, each loop extending via ($V_{0\_1}$, $C_1$), and ($V_{0\_1}$, $C_2$) has also a loop length of g or longer.

In addition, each loop extending via ($V_{0\_0}$, $C_0$) and ($V_{0\_1}$, $C_2$) has a loop length of g+2 or longer.

Furthermore, because the branches are added in such a way that no loop is produced newly, no loop having a loop length of shorter than g exists.
(I) As mentioned above, when the graph $G_0{}^g$ representing the check matrix of an LDPC code in QC satisfies the following conditions

(1) and (2), the graph $\underline{G}_0{}^g$ which is produced after the division is done also has an inner diameter of g or larger.
(1) $V_x$ or Cy is divided without changing the value of $I(p_{j,1})$ extending via $V_x$ and Cy.
(2) No loop exists in the subgraph which is produced after the division and is comprised of $V_x$ and Cy.

(II) Next, consider a connection between different graphs.

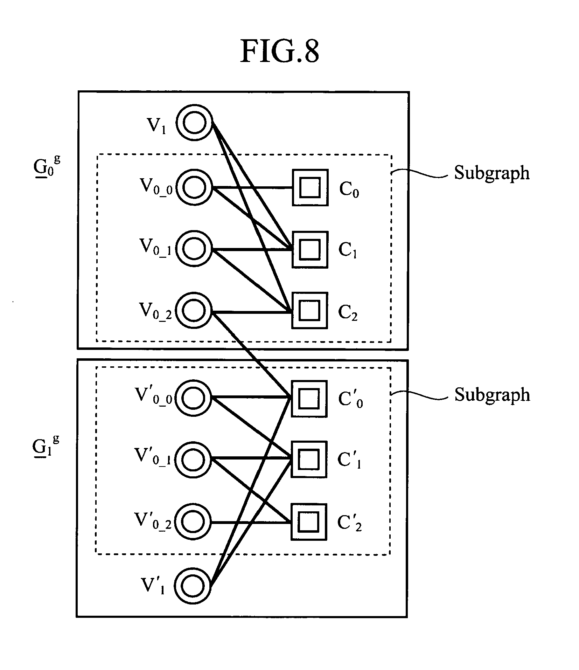

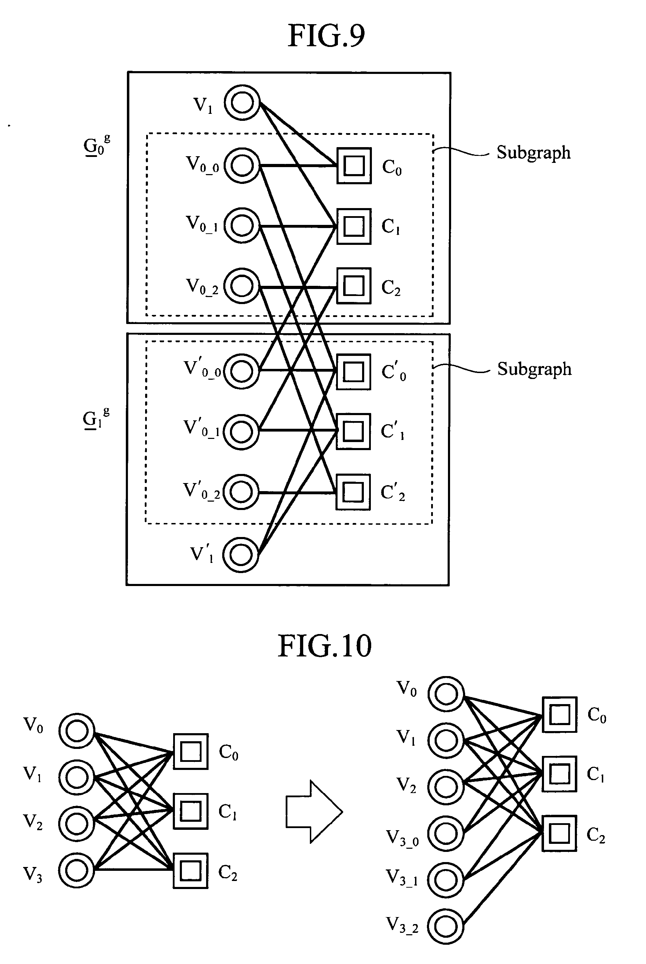

When different graphs are connected to each other via p branches (for example, as illustrated in Fig. 8, different graphs are connected to each other via a single thick branch, although this single thick branch is a set of p branches), each of loops including the branches has a loop length of ten or larger.
For example, as shown in Fig. 8, when two graphs $\underline{G}_0{}^g$ and $\underline{G}_1{}^g$ are connected to each other via p branches (which is one set of p branches), it is necessary for each of the loops including the branches to go via the 2*p branches (the two sets of p branches) in order to connect the two graphs $\underline{G}_0{}^g$ and $\underline{G}_1{}^g$ because the shortest loop of each graph is a 4-length loop.
Accordingly, there is a possibility that each of the loops including the branches has a loop length=4+4+2=10, and their shortest loop length is ten or longer.
Furthermore, as shown in Fig. 9, in a case in which two or more graphs are subjected to a division based on the conditions shown in (I), two graphs on which the division is performed are connected by using 2*p branches (the two sets of p branches) or more in such a way that subgraphs each of which consist of nodes on which a division which does not produce any loop has been performed are connected to each other, and each of the subgraphs to which those branches are added does not include any loop, the shortest loop including those branches has a loop length of eight or longer.
When the above-mentioned conditions are satisfied, a connection between two graphs using 2*p branches (two sets of p branches) requires 2*p branches (two sets of p branches) for each of outward and return paths.
Because 2*p branches (two sets of p branches) in each of the graphs are adequate to form a loop, there is a possibility that each loop including the branches has a loop length=2+2+2+2=8, and the shortest loop including the branches has a loop length of eight or longer.

[Example of configuration of an LDPC code]

Hereafter, a code which is configured according to the above-mentioned configuration conditions will be shown as an example.
For example, check matrices corresponding to graphs $G_0{}^{10}$ and $G_1{}^{10}$ are expressed as $H_0{}^{10}$ and $H_1{}^{10}$ respectively, and it is assumed that the check matrices $H_0{}^{10}$ and $H_1{}^{10}$ have the following configurations respectively. In the matrices, each numeral shows $p_{j,l}$, and each null shows a $p \times p$ zero matrix.

$$H_0^{10} = \begin{bmatrix} 0 & 11 & 0 & 0 \\ 1 & 7 & 8 & 0 \\ 3 & 20 & 31 & 0 \end{bmatrix} H_1^{10} = \begin{bmatrix} 0 & 14 & 4 & 0 \\ 10 & 1 & 8 & 0 \\ 17 & 41 & 7 & 0 \end{bmatrix}, p = 49$$

Furthermore, each of these two check matrices $H_0{}^{10}$ and $H_1{}^{10}$ is divided in such a way that check matrices $\underline{H}_0{}^{10}$ and $\underline{H}_1{}^{10}$ corresponding to graphs $\underline{G}_0{}^{10}$ and $\underline{G}_1{}^{10}$ are configured.

$$\underline{H}_0^{10} = \begin{bmatrix} 0 & 11 & 0 & 0 & \\ 1 & 7 & 8 & 0 & 0 \\ 3 & 20 & 31 & & 0 & 0 \end{bmatrix}, \quad \underline{H}_1^{10} = \begin{bmatrix} 0 & 14 & 4 & 0 & \\ 10 & 1 & 8 & 0 & 0 \\ 17 & 41 & 7 & & 0 & 0 \end{bmatrix}, \quad p = 49$$

The above-mentioned conversion of the graph $G_0{}^{10}$ into the graph $\underline{G}_0{}^{10}$ is represented by a graph, as shown in Fig. 10.

The conversion of the graph $G_1{}^{10}$ into the graph $\underline{G}_1{}^{10}$ is similarly represented by a graph.

Next, the following check matrix $\underline{H}_{0,1}$ is created by using the check matrices $\underline{H}_0{}^{10}$ and $\underline{H}_1{}^{10}$.

$$\underline{H}_{0,1} = \begin{bmatrix} 0 & 11 & 0 & & & & & 0 & & & \\ & & & 0 & 14 & 4 & 0 & 0 & & & \\ 1 & 7 & 8 & & & & & & 0 & 0 & \\ & & & 10 & 1 & 8 & & & 0 & 0 & \\ 3 & 20 & 31 & & & & & & & 0 & 0 \\ & & & 17 & 41 & 7 & & & & & 0 & 0 \end{bmatrix}$$

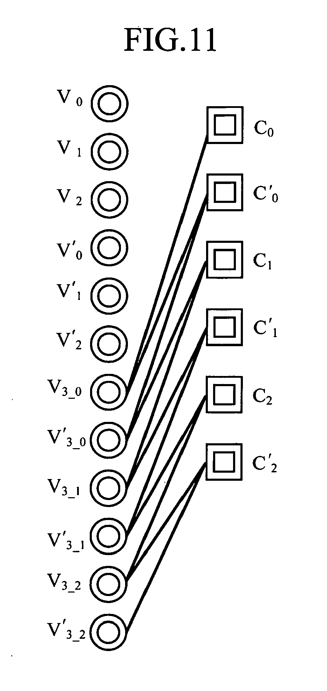

This graph is represented as shown in Fig. 11.

In Fig. 11, each node denoted by reference characters not including "'" is a node for the graph $\underline{G}_0{}^{10}$, and each node denoted by reference characters including "'" is a node for the graph $\underline{G}_1{}^{10}$.

In the graph of Fig. 11, only connections with each divided node are represented by branches to avoid the complexity of the graph.

This $\underline{H}_{0,1}$ is an example represented, as the check matrix, by connecting different graphs of g=10 to form a new graph.

In this case, $\underline{H}_{0,1}{}^{10}$ has an inner diameter of eight or larger according to the condition (2) of (II). Because designing a check matrix having an inner diameter of eight or larger is a difficult issue, it is desired that an advantage of adequately guaranteeing the performance characteristics of the check matrix creation device is provided.

[Combination with a submatrix having a large column weight and a small inner diameter]

In general, an inner diameter exerts a large influence upon a portion having a small column weight.

In the above-mentioned example, a combination with a submatrix having g=10 is shown. However, it has turned out that, if the submatrix has a large column weight, the performance characteristics of the check matrix creation device do not degrade greatly even though the subgraph corresponding to the submatrix having the large column weight has an inner diameter of g=6 or g=8.

Therefore, only the inner diameter of a submatrix corresponding to a portion having a large column weight can be reduced relatively as follows.

$$g = 8 \qquad g = 1\,0$$

$$\underline{H'}_{0,1} = \begin{bmatrix} 0 & 0 \\ 1 & 2 \\ 3 & 6 \\ 4 & 8 \\ 9 & 18 \\ 10 & 20 \end{bmatrix} \begin{pmatrix} 0 & 11 & 0 & & & & & 0 & & & \\ & & & 0 & 14 & 4 & 0 & 0 & & \\ 1 & 7 & 8 & & & & & & 0 & 0 \\ & & & 10 & 1 & 8 & & & 0 & 0 \\ 3 & 20 & 31 & & & & & & & 0 & 0 \\ & & & 17 & 41 & 7 & & & & & 0 & 0 \end{pmatrix}$$

[Process of reducing columns having a column weight of "1"]

In the above-mentioned check matrix $\underline{H'}_{0,1}$, because a portion of $p_{5,13}= 0$ has a column weight of "1", the weights of p columns are all "1".
In general, because an error floor can occur when there are a large number of columns having a weight of "1", it is desirable that the number of columns having a weight of "1" is small.
On the other hand, because a stair-like arrangement of "0s" forms a lower triangular matrix and has a configuration required for the code creation, it is preferable to maintain the configuration of the lower triangular matrix.
As a method of reducing the number of columns having a weight of "1" in the state in which this configuration is maintained, a circulant permutation matrix having a column weight of "1" is converted as follows. As a result, the number of columns having a column weight of "1" can be reduced from p to 1.
$$I(0) = \begin{bmatrix} 1 & & & & \\ & 1 & & & \\ & & \ddots & & \\ & & & 1 & \\ & & & & 1 \end{bmatrix} \implies I(0'') = \begin{bmatrix} 1 & & & & \\ 1 & 1 & & & \\ & \ddots & \ddots & & \\ & & 1 & 1 & \\ & & & 1 & 1 \end{bmatrix}$$

The whole of the check matrix is converted as follows.
In this case, the check matrix is simply represented only by using $p_{j},_1$ of $I(p_{j},_1)$ in the following expression. Furthermore, the above-mentioned conversion is expressed as $p_{j,1}=0''$.

$$\underline{H''}_{0,1} = \begin{bmatrix} 0 & 0 & 0 & 11 & 0 & & & & & 0 & & \\ 1 & 2 & & & & 0 & 14 & 4 & 0 & 0 & & \\ 3 & 6 & 1 & 7 & 8 & & & & & 0 & 0 \\ 4 & 8 & & & & 10 & 1 & 8 & & & 0 & 0 \\ 9 & 18 & 3 & 20 & 31 & & & & & & 0 & 0 \\ 10 & 20 & & & & 17 & 41 & 7 & & & & 0 & 0'' \end{bmatrix}, p = 49$$

As can be seen from the above description, because the check matrix creation device in accordance with this Embodiment 1 is constructed in such a way as to include the circulant permutation matrix setting unit 12 for preparing a plurality of circulant permutation matrices each having an inner diameter of six or larger, and the quasi-cyclic matrix creation unit 13 for arranging the plurality of circulant permutation matrices prepared by the circulant permutation matrix setting unit 12 both in the row direction and in the column direction to create a quasi-cyclic matrix, there is provided an advantage of being able to create a parity-check matrix for an irregular LDPC code which has a better performance than that created using a method of forming a check matrix through a computer search, and which has a regular configuration and can support a wide range of coding rates.

Embodiment 2.

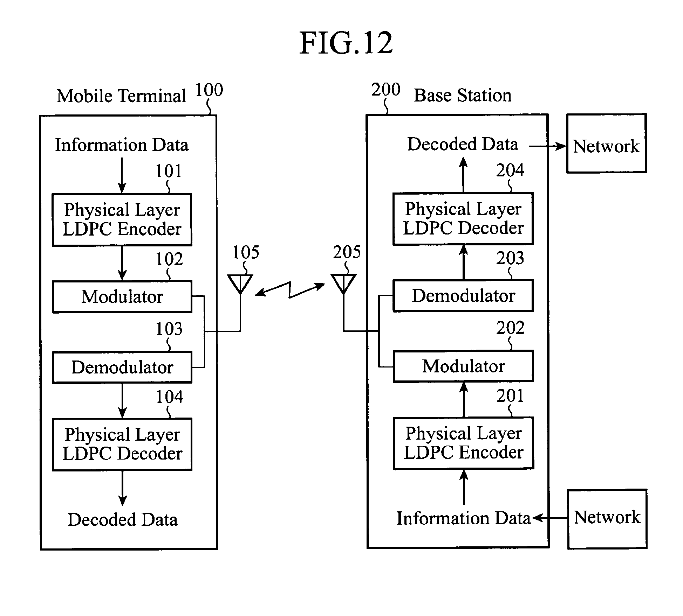

Fig. 12 is a block diagram showing a communication system in accordance with Embodiment 2 of the present invention.

In above-mentioned Embodiment 1, the example in which the communication device on the transmit side is the transmitter 1 and the communication device on the receive side is the receiver 3 is shown (refer to Fig. 1). In contrast, in this Embodiment 2, an example in which a mobile terminal 100 and a base station 200 transmit and receive data to and from each other is shown.

In the figure, a physical layer LDPC encoder 101 of the mobile terminal 100 is applied to a fading communication channel or the like in a physical layer, and constructs the LDPC encoder 14 of Fig. 1. Furthermore, the physical layer LDPC encoder 101 can include the check matrix creation device 11 of Fig. 1, or the check matrix creation device 11 of Fig. 1 can be disposed separately from the physical layer LDPC encoder 101.

A modulator 102 of the mobile terminal 100 carries out a process of modulating a codeword created by the physical layer LDPC encoder 101, and sending out a modulated signal of the codeword onto a radio channel by using an antenna 105.

A demodulator 103 of the mobile terminal 100 carries out a process of, when the antenna 105 receives a modulated signal of a codeword transmitted from the base station 200 (a received signal including an error occurring in the radio channel), demodulating the modulated signal.

A physical layer LDPC decoder 104 of the mobile terminal 100 is applied to the fading communication channel or the like in the physical layer, and constructs the LDPC decoder 25 of Fig. 1. Furthermore, the physical layer LDPC decoder 104 can include the check matrix creation device 21 of Fig. 1, or the check matrix creation device 21 of Fig. 1 can be disposed separately from the physical layer LDPC decoder 104.

A physical layer LDPC encoder 201 of the base station 200 is applied to a fading communication channel or the like in the physical layer, and constructs the LDPC encoder 14 of Fig. 1. Furthermore, the physical layer LDPC encoder 201 can include the check matrix creation device 11 of Fig. 1, or the check matrix creation device 11 of Fig. 1 can be disposed separately from the physical layer LDPC encoder 201.

A modulator 202 of the base station 200 carries out a process of modulating a codeword created by the physical layer LDPC encoder 201, and sending out a modulated signal of the codeword onto a radio channel by using an antenna 205.

A demodulator 203 of the base station 200 carries out a process of, when the antenna 205 receives a modulated signal of a codeword transmitted from the mobile terminal 100 (a received signal including an error occurring in the radio channel) demodulating the modulated signal. A physical layer LDPC decoder 204 of the base station 200 is applied to the fading communication channel or the like in the physical layer, and constructs the LDPC decoder 25 of Fig. 1. Furthermore, the physical layer LDPC decoder 204 can include the check matrix creation device 21 of Fig. 1, or the check matrix creation device 21 of Fig. 1 can be disposed separately from the physical layer LDPC decoder 204.

Next, the operation of the communication system will be explained.

When the mobile terminal 100 transmits data to the base station 200, the physical layer LDPC encoder 101 for the fading communication channel encodes the data on a per-packet-data basis in the physical layer. The encoding process is the same as that carried out by the LDPC encoder 14 of Fig. 1.

When the physical layer LDPC encoder 101 creates coded data, the modulator 102 of the mobile terminal 100 modulates the coded data, and sends out a modulated signal of the coded data onto the radio channel by using the antenna 105.

When the antenna 205 receives the modulated signal of the codeword transmitted from the mobile terminal 100 (the received signal including an error occurring in the radio channel), the demodulator 203 of the base station 200 demodulates the modulated signal.

The physical layer LDPC decoder 204 of the base station 200 corrects the error of the data by performing the same decoding process as that carried out by the LDPC decoder 25 of Fig. 1 on the demodulated result obtained by the demodulator 203 to generate the data.

In the physical layer, the physical layer LDPC decoder 204 informs information showing whether the physical layer LDPC decoder has succeeded in the error correction on a per-packet basis to an upper hierarchical layer, and transmits the error-corrected data to the communication partner via the network.

In a case in which the base station 200 transmits data to the mobile terminal 100, when the physical layer LDPC encoder 201 for the fading communication channel receives the data, via the network, from the communication partner in the physical layer, the physical layer LDPC encoder 201 encodes the data on a per-packet-data basis. The encoding process is the same as that carried out by the LDPC encoder 14 of Fig. 1.

When the physical layer LDPC encoder 201 creates coded data, the modulator 202 of the base station 200 modulates the coded data, and sends out a modulated signal of the coded data onto the radio channel by using the antenna 205.

When the antenna 105 receives the modulated signal of the codeword transmitted from the base station 200 (the received signal including an error occurring in the radio channel), the demodulator 103 of the mobile terminal 100 demodulates the modulated signal.

The physical layer LDPC decoder 104 of the mobile station 100 corrects the error of the data by performing the same decoding process as that carried out by the LDPC decoder 25 of Fig. 1 on the demodulated result obtained by the demodulator 103 to reproduce the data.

In the physical layer, the physical layer LDPC decoder 104 informs information showing whether the physical layer LDPC decoder has succeeded in the error correction on a per-packet basis to an upper hierarchical layer

In this Embodiment 2, the example in which the communication channel is a radio channel is shown, although the communication channel is not limited to a radio channel. For example, the communication channel can be a radio LAN, an optical communication channel, or a satellite communication channel.

Furthermore, in this Embodiment 2, the example in which the communication devices are the mobile terminal 100 and the base station 200 is shown, although the communication devices are not limited to the mobile terminal 100 and the base station 200. For example, the communication devices can be quantum encryption devices or the like, and this embodiment can be widely applied to whole fields of communication equipment.

Embodiment 3.

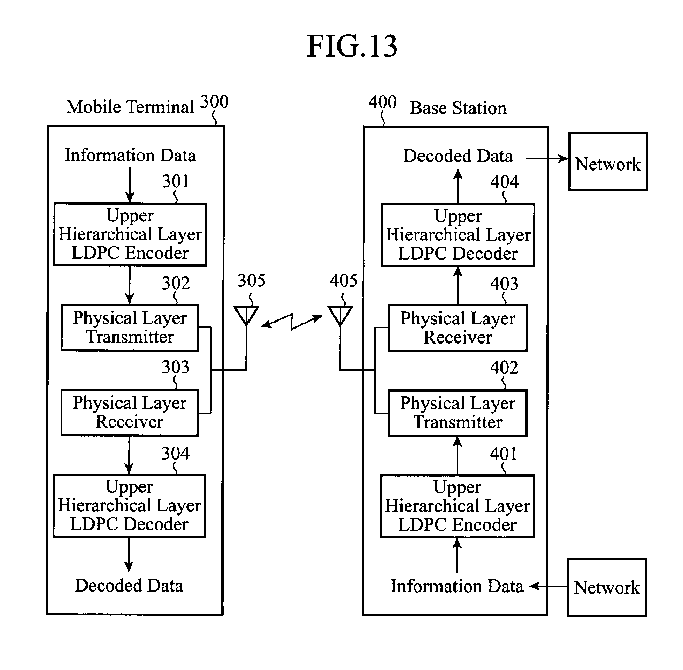

Fig. 13 is a block diagram showing a communication system in accordance with Embodiment 3 of the present invention.

In above-mentioned Embodiment 1, the example in which the communication device on the transmit side is the transmitter 1 and the communication device on the receive side is the receiver 3 is shown (refer to Fig. 1). In contrast, in this Embodiment 3, an example in which a mobile terminal 300 and a base station 400 transmit and receive data to and from each other is shown.

In the figure, an upper hierarchical layer LDPC encoder 301 of the mobile terminal 300 is applied to a correction or the like in an upper hierarchical layer of a packet error occurring in a fading communication channel or the like, and constructs the LDPC encoder 14 of Fig. 1. Furthermore, the upper hierarchical layer LDPC encoder 301 can include the check matrix creation device 11 of Fig. 1, or the check matrix creation device 11 of Fig. 1 can be disposed separately from the upper hierarchical layer LDPC encoder 301.

A physical layer transmitter 302 of the mobile terminal 300 carries out a process of modulating a codeword created by the upper hierarchical layer LDPC encoder 301, and sending out a modulated signal of the codeword onto a radio channel by using an antenna 305.

When the antenna 305 receives a modulated signal of a codeword transmitted from the base station 400 (a received signal including an error occurring in the radio channel), a physical layer receiver 303 of the mobile terminal 300 carries out a process of demodulating the modulated signal. An upper hierarchical layer LDPC decoder 304 of the mobile terminal 300 is applied to a correction or the like in the upper hierarchical layer of a packet error occurring in the fading communication channel or the like, and constructs the LDPC decoder 25 of Fig. 1. Furthermore, the upper hierarchical layer LDPC decoder 304 can include the check matrix creation device 21 of Fig. 1, or the check matrix creation device 21 of Fig. 1 can be disposed separately from the upper hierarchical layer LDPC decoder 304.

An upper hierarchical layer LDPC encoder 401 of the base station 400 is applied to a correction or the like in an upper hierarchical layer of a packet error occurring in a fading communication channel or the like, and constructs the LDPC encoder 14 of Fig. 1. Furthermore, the upper hierarchical layer LDPC encoder 401 can include the check matrix creation device 11 of Fig. 1, or the check matrix creation device 11 of Fig. 1 can be disposed separately from the upper hierarchical layer LDPC encoder 401.

A physical layer transmitter 402 of the base station 400 carries out a process of modulating a codeword created by the upper hierarchical layer LDPC encoder 401, and sending out a modulated signal of the codeword onto a radio channel by using an antenna 405.

When the antenna 405 receives a modulated signal of a codeword transmitted from the mobile terminal 300 (a received signal including an error occurring in the radio channel), a physical layer receiver 403 of the base station 400 carries out a process of demodulating the modulated signal. An upper hierarchical layer LDPC decoder 404 of the base station 400 is applied to a correction or the like in the upper hierarchical layer of a packet error occurring in the fading communication channel or the like, and constructs the LDPC decoder 25 of Fig. 1. Furthermore, the upper hierarchical layer LDPC decoder 404 can include the check matrix creation device 21 of Fig. 1, or the check matrix creation device 21 of Fig. 1 can be disposed separately from the upper hierarchical layer LDPC decoder 404.

Next, the operation of the communication system will be explained.

When the mobile terminal 300 transmits data to the base station 400, in the upper hierarchical layer, the upper hierarchical layer LDPC encoder 301 for the fading communication channel encodes the data on a per-packet-data basis. The encoding process is the same as that carried out by the LDPC encoder 14 of Fig. 1.

When the upper hierarchical layer LDPC encoder 301 creates coded data, the physical layer transmitter 302 of the mobile terminal 300 modulates the coded data in the physical layer, and sends out a modulated signal of the coded data onto the radio channel by using the antenna 305.

When the antenna 405 receives the modulated signal of the codeword transmitted from the mobile terminal 300 (the received signal including an error occurring in the radio channel), the physical layer receiver 403 of the base station 400 demodulates the modulated signal in the physical layer.

The upper hierarchical layer LDPC decoder 404 of the base station 400 performs the same decoding process as that performed by the LDPC decoder 25 of Fig. 1 on the demodulated result obtained by the physical layer receiver 403, and then corrects the error of the data by generating the data in the upper hierarchical layer.

When an error correction has been made on a per-packet basis, the upper hierarchical layer LDPC decoder 404 transmits the error-corrected data to the communication partner via the network.

In a case in which the base station 400 transmits data to the mobile terminal 300, when the upper hierarchical layer LDPC encoder 401 for the fading communication channel receives the data via the network from the communication partner, the upper hierarchical layer LDPC encoder encodes the data on a per-packet-data basis in the upper hierarchical layer. The encoding process is the same as that carried out by the LDPC encoder 14 of Fig. 1.

When the upper hierarchical layer LDPC encoder 401 creates coded data, the physical layer transmitter 402 of the base station 400 modulates the coded data in the physical layer, and sends out a modulated signal of the coded data onto the radio channel by using the antenna 405.

When the antenna 305 receives the modulated signal of the codeword transmitted from the base station 400 (the received signal including an error occurring in the radio channel), the physical layer receiver 303 of the mobile terminal 300 demodulates the modulated signal.

The upper hierarchical physical layer LDPC decoder 304 of the mobile station 300 corrects the error of the data by performing the same decoding process as that carried out by the LDPC decoder 25 of Fig. 1 on the demodulated result obtained by the physical layer receiver 303 in the upper hierarchical layer to reproduce the data.

In this Embodiment 3, the example in which the communication channel is a radio channel is shown, although the communication channel is not limited to a radio channel. For example, the communication channel can be a radio LAN, an optical communication channel, or a satellite communication channel.

Furthermore, in this Embodiment 3, the example in which the communication devices are the mobile terminal 300 and the base station 400 is shown, although the communication devices are not limited to the mobile terminal 300 and the base station 400. For example, the communication devices can be quantum encryption devices or the like, and this embodiment can be widely applied to whole fields of communication equipment.

Embodiment 4.

In this Embodiment 4, a concrete example of the parity-check matrix is shown explicitly.

For example, the following check matrix $H_{CH}$ is the one of a code having a coding rate of 1/2 which is used by the International Standards IEEE802.16e. In the check matrix, each numeral shows $p_{j,1}$, and "-1" shows a $p \times p$ zero matrix.

$$H_{CH} = \begin{bmatrix}
-1 & 94 & 73 & -1 & -1 & -1 & -1 & -1 & 55 & 83 & -1 & -1 & 7 & 0 & -1 & -1 & -1 & -1 & -1 & -1 & -1 & -1 & -1 & -1 \\
-1 & 27 & -1 & -1 & -1 & 22 & 79 & 9 & -1 & -1 & -1 & 12 & -1 & 0 & 0 & -1 & -1 & -1 & -1 & -1 & -1 & -1 & -1 & -1 \\
-1 & -1 & -1 & 24 & 22 & 81 & -1 & 33 & -1 & -1 & -1 & 0 & -1 & -1 & 0 & 0 & -1 & -1 & -1 & -1 & -1 & -1 & -1 & -1 \\
61 & -1 & 47 & -1 & -1 & -1 & -1 & -1 & 65 & 25 & -1 & -1 & -1 & -1 & -1 & 0 & 0 & -1 & -1 & -1 & -1 & -1 & -1 & -1 \\
-1 & -1 & 39 & -1 & -1 & -1 & 84 & -1 & -1 & 41 & 72 & -1 & -1 & -1 & -1 & -1 & 0 & 0 & -1 & -1 & -1 & -1 & -1 & -1 \\
-1 & -1 & -1 & -1 & 46 & 40 & -1 & 82 & -1 & -1 & -1 & 79 & 0 & -1 & -1 & -1 & -1 & 0 & 0 & -1 & -1 & -1 & -1 & -1 \\
-1 & -1 & 95 & 53 & -1 & -1 & -1 & -1 & -1 & 14 & 18 & -1 & -1 & -1 & -1 & -1 & -1 & -1 & 0 & 0 & -1 & -1 & -1 & -1 \\
-1 & 11 & 73 & -1 & -1 & -1 & 2 & -1 & -1 & 47 & -1 & -1 & -1 & -1 & -1 & -1 & -1 & -1 & -1 & 0 & 0 & -1 & -1 & -1 \\
12 & -1 & -1 & -1 & 83 & 24 & -1 & 43 & -1 & -1 & -1 & 51 & -1 & -1 & -1 & -1 & -1 & -1 & -1 & -1 & 0 & 0 & -1 & -1 \\
-1 & -1 & -1 & -1 & -1 & 94 & -1 & 59 & -1 & -1 & 70 & 72 & -1 & -1 & -1 & -1 & -1 & -1 & -1 & -1 & -1 & 0 & 0 & -1 \\
-1 & -1 & 7 & 65 & -1 & -1 & -1 & -1 & 39 & 49 & -1 & -1 & -1 & -1 & -1 & -1 & -1 & -1 & -1 & -1 & -1 & -1 & 0 & 0 \\
43 & -1 & -1 & -1 & -1 & 66 & -1 & 41 & -1 & -1 & -1 & 26 & 7 & -1 & -1 & -1 & -1 & -1 & -1 & -1 & -1 & -1 & -1 & 0
\end{bmatrix}$$

Next, an example of an extension of this check matrix $H_{CH}$ to create a check matrix having a coding rate of 1/3 is shown. In this example, a portion designated by A and two portions designated by I are designed by using the method in accordance with the present invention.

```
-1 94 73 -1 -1 -1 -1 -1 55 83 -1 -1  7  0 -1 -1 -1 -1 -1 -1 -1 -1 -1 -1 | -1 -1 -1 -1 -1 -1 -1 -1 -1 -1 -1 -1
-1 27 -1 -1 -1 22 79  9 -1 -1 -1 12 -1  0  0 -1 -1 -1 -1 -1 -1 -1 -1 -1 | -1 -1 -1 -1 -1 -1 -1 -1 -1 -1 -1 -1
-1 -1 -1 24 22 81 -1 33 -1 -1 -1  0 -1 -1  0  0 -1 -1 -1 -1 -1 -1 -1 -1 | -1 -1 -1 -1 -1 -1 -1 -1 -1 -1 -1 -1
61 -1 47 -1 -1 -1 -1 -1 65 25 -1 -1 -1 -1 -1  0  0 -1 -1 -1 -1 -1 -1 -1 | -1 -1 -1 -1 -1 -1 -1 -1 -1 -1 -1 -1
-1 -1 39 -1 -1 -1 84 -1 -1 41 72 -1 -1 -1 -1 -1  0  0 -1 -1 -1 -1 -1 -1 | -1 -1 -1 -1 -1 -1 -1 -1 -1 -1 -1 -1
-1 -1 -1 46 40 -1 82 -1 -1 -1 79  0 -1 -1 -1  0  0 -1 -1 -1 -1 -1 -1 -1 | -1 -1 -1 -1 -1 -1 Q -1 -1 -1 -1 -1
-1 -1 95 53 -1 -1 -1 -1 14 18 -1 -1 -1 -1 -1 -1  0  0 -1 -1 -1 -1 -1 -1 | -1 -1 -1 -1 -1 -1 -1 -1 -1 -1 -1 -1
-1 11 73 -1 -1 -1  2 -1 -1 47 -1 -1 -1 -1 -1 -1  0  0 -1 -1 -1 -1 -1 -1 | -1 -1 -1 -1 -1 -1 -1 -1 -1 -1 -1 -1
12 -1 -1 -1 83 24 -1 43 -1 -1 -1 51 -1 -1 -1 -1 -1 -1  0  0 -1 -1 -1 -1 | -1 -1 -1 -1 -1 -1 -1 -1 -1 -1 -1 -1
-1 -1 -1 -1 94 -1 59 -1 -1 70 72 -1 -1 -1 -1 -1 -1 -1 -1  0  0 -1 -1 -1 | -1 -1 -1 -1 -1 -1 -1 -1 -1 -1 -1 -1
-1 -1  7 65 -1 -1 -1 -1 39 49 -1 -1 -1 -1 -1 -1 -1 -1 -1 -1  0  0 -1 -1 | -1 -1 -1 -1 -1 -1 -1 -1 -1 -1 -1 -1
43 -1 -1 -1 -1 66 -1 41 -1 -1 -1 26  7 -1 -1 -1 -1 -1 -1 -1 -1 -1  0  0 | -1 -1 -1 -1 -1 -1 -1 -1 -1 -1 -1 -1
```

```
-1 -1  0 -1 -1  0 -1  0 -1 -1 -1 -1 -1 -1 -1 -1 -1 -1 -1 -1 -1 | 0 -1 -1 -1 -1 -1 -1 -1 -1 -1 -1 -1
-1 -1 -1 -1 -1 -1 -1 -1 28 -1 56 -1  0 -1 -1 -1 -1 -1 -1 -1 -1 |-1  0 -1 -1 -1 -1 -1 -1 -1 -1 -1 -1
-1 -1  2 -1 -1  4 -1 10 -1 -1 -1 -1 -1 -1  0 -1 -1 -1 -1 -1 -1 |-1 -1  0 -1 -1 -1 -1 -1 -1 -1 -1 -1
-1 -1 -1 -1 -1 -1 -1 -1 32 -1 64 -1 -1 -1 -1  0 -1 -1 -1 -1 -1 |-1 -1 -1  0 -1 -1 -1 -1 -1 -1 -1 -1
-1  6 -1 -1 12 -1 36 -1 -1 -1 -1 -1 -1 -1 -1 -1  0 -1 -1 -1 -1 |-1 -1 -1 -1  0 -1 -1 -1 -1 -1 -1 -1
-1 -1 -1 -1 -1 -1 -1 -1 38 -1 58 -1 -1 -1 -1 -1 -1  0 -1 -1 -1 |-1 -1 -1 -1 -1  0 -1 -1 -1 -1 -1 -1
-1 -1 14 -1 -1 28 -1 62 -1 -1 -1 -1 -1 -1 -1 -1 -1 -1  0 -1 -1 |-1 -1 -1 -1 -1 -1  0 -1 -1 -1 -1 -1
-1 -1 -1 -1 -1 -1 -1 -1  0 -1  0 -1 -1 -1 -1 -1 -1 -1 -1  0 -1 |-1 -1 -1 -1 -1 -1 -1  0 -1 -1 -1 -1
-1 -1 16 -1 -1 32 -1 86 -1 -1 -1 -1 -1 -1 -1 -1 -1 -1 -1 -1  0 |-1 -1 -1 -1 -1 -1 -1 -1  0 -1 -1 -1
-1 -1 -1 -1 -1 -1 -1 -1 -1  4 -1  8 -1 -1 -1 -1 -1 -1 -1 -1 -1 |-1 -1 -1 -1 -1 -1 -1 -1 -1  0 -1 -1
-1 -1 20 -1 -1 40 -1 78 -1 -1 -1 -1 -1 -1 -1 -1 -1 -1 -1 -1 -1 |-1 -1 -1 -1 -1 -1 -1 -1 -1 -1  0 -1
-1 -1 -1 -1 -1 -1 -1 -1 -1 10 -1  2 -1 -1 -1 -1 -1 -1 -1 -1  0 |-1 -1 -1 -1 -1 -1 -1 -1 -1 -1 -1  0
```

Each of the portion designate by A and the two portions designated by I in the above-mentioned example is divided by using the following two check matrices of g=8.

$$
\begin{bmatrix}
0 & 0 & 0 & 0 \\
0 & 2 & 4 & 10 \\
0 & 6 & 12 & 36 \\
0 & 14 & 28 & 62 \\
0 & 16 & 32 & 86 \\
0 & 20 & 40 & 78
\end{bmatrix}
\begin{bmatrix}
0 & 0 & 0 \\
0 & 4 & 8 \\
0 & 10 & 2 \\
0 & 28 & 56 \\
0 & 32 & 64 \\
0 & 38 & 58
\end{bmatrix}
$$

Embodiment 5.

In this Embodiment 5, an example of the check matrix H having a coding rate of 3/4 is shown explicitly. In this check matrix H, p=1,620.

```
       4  14  15  45  -1 -1 -1 -1 -1 -1 -1 | 0  76   2  76  20   4 -1 306 35 | -1 -1 -1 -1 -1 -1 -1 -1 -1 -1 | 0 -1 -1 -1 -1 -1 -1 -1
       1   5  19   5  24 95 36 38  3 12 28 | -1 -1 -1 -1 -1 -1 -1 -1 -1 | -1 -1 -1 -1 -1 -1 -1 -1 -1 -1 | 0  0 -1 -1 -1 -1 -1 -1
       0   2  39  81  -1 -1 -1 -1 -1 -1 -1 | -1 -1 -1  0  0 58 12   1  38 238 114 87 31 | -1  0  0 -1 -1 -1 -1 -1
       8   1  67   7  -1 -1 -1 -1 -1 -1 -1 | 10 152 160 34 190 -1 200 226 -1 | -1 -1 -1 -1 -1 -1 -1 -1 -1 | -1 -1  0  0 -1 -1 -1 -1
H =    6   9   1 120 123 13 209 180  4 114 111 | -1 -1 -1 -1 -1 -1 -1 -1 -1 | -1 -1 -1 -1 -1 -1 -1 | -1 -1 -1  0  0 -1 -1 -1
       2  50  91   8  -1 -1 -1 -1 -1 -1 -1 | -1 -1 -1 -1 -1 -1 -1 -1 -1  8 38 40 142 152 226 160 204  1 25 | -1 -1 -1 -1  0  0 -1 -1
       7  41 105  16  -1 -1 -1 -1 -1 -1 -1 | 17 133 30  2 323 77   9 -1 259 | -1 -1 -1 -1 -1 -1 -1 -1 -1 | -1 -1 -1 -1 -1  0  0 -1
       3  18  57  60  18 342 345 60 31 100 34 | -1 -1 -1 -1 -1 -1 -1 -1 -1 | -1 -1 -1 -1 -1 -1 -1 -1 -1 | -1 -1 -1 -1 -1 -1  0  0
       5  19  38  77  -1 -1 -1 -1 -1 -1 -1 | -1 95 16 96 35 24 73 13 323 147 | -1 -1 -1 -1 -1 -1 -1 -1 -1 | -1 -1 -1 -1 -1 -1 -1  0  0
      19  30 141   6  -1 -1 -1 -1 -1 -1 -1 | 6 73 30 167 | -1 -1 -1 -1 -1 -1 -1 -1 -1 | -1 -1 -1 -1 -1 -1 -1  0  0
```

$$g = 6 \qquad g = 10$$

The above-mentioned example is configured by a combination of a matrix based on three graphs of g=10, and a matrix based on one graph of g=6.

It is also possible to delete some columns to create a check matrix having a lower coding rate as follows. In this example, the check matrix has a coding rate of 5/7. Furthermore, in this check matrix, p=1,852.

$$H=\begin{bmatrix}
4 & 14 & 15 & 45 & -1 & -1 & -1 & -1 & -1 & -1 & -1 & 0 & 76 & 2 & 76 & 20 & 4 & -1 & 308 & 35 & -1 & -1 & -1 & -1 & -1 & 0 & -1 & -1 & -1 & -1 & -1 & -1 & -1 & -1 & -1 \\
1 & 5 & 19 & 5 & 24 & 95 & 36 & 38 & 3 & 12 & 28 & -1 & -1 & -1 & -1 & -1 & -1 & -1 & -1 & -1 & -1 & -1 & -1 & -1 & -1 & 0 & 0 & -1 & -1 & -1 & -1 & -1 & -1 & -1 & -1 \\
0 & 2 & 39 & 81 & -1 & -1 & -1 & -1 & -1 & -1 & -1 & -1 & -1 & -1 & -1 & -1 & -1 & -1 & -1 & -1 & 0 & 0 & 58 & 12 & 1 & -1 & 0 & 0 & -1 & -1 & -1 & -1 & -1 & -1 & -1 \\
8 & 1 & 67 & 7 & -1 & -1 & -1 & -1 & -1 & -1 & -1 & 10 & 152 & 160 & 34 & 190 & -1 & 200 & 226 & -1 & -1 & -1 & -1 & -1 & -1 & -1 & -1 & 0 & 0 & -1 & -1 & -1 & -1 & -1 & -1 \\
6 & 9 & 1 & 120 & 123 & 13 & 209 & 180 & 4 & 114 & 11 & -1 & -1 & -1 & -1 & -1 & -1 & -1 & -1 & -1 & -1 & -1 & -1 & -1 & -1 & -1 & -1 & 0 & 0 & -1 & -1 & -1 & -1 & -1 & -1 \\
2 & 50 & 91 & 8 & -1 & -1 & -1 & -1 & -1 & -1 & -1 & -1 & -1 & -1 & -1 & -1 & -1 & 8 & 38 & 40 & 142 & 152 & -1 & -1 & -1 & -1 & 0 & 0 & -1 & -1 & -1 & -1 & -1 & -1 & -1 \\
7 & 41 & 105 & 16 & -1 & -1 & -1 & -1 & -1 & -1 & -1 & 17 & 133 & 30 & 2 & 323 & 77 & 9 & -1 & 259 & -1 & -1 & -1 & -1 & -1 & -1 & -1 & -1 & 0 & 0 & -1 & -1 & -1 & -1 & -1 \\
3 & 18 & 57 & 60 & 18 & 342 & 345 & 60 & 31 & 100 & 34 & -1 & -1 & -1 & -1 & -1 & -1 & -1 & -1 & -1 & -1 & -1 & -1 & -1 & -1 & -1 & -1 & -1 & -1 & 0 & 0 & -1 & -1 & -1 & -1 \\
5 & 19 & 38 & 77 & -1 & -1 & -1 & -1 & -1 & -1 & -1 & -1 & -1 & -1 & -1 & -1 & -1 & 1 & 95 & 16 & 96 & 35 & -1 & -1 & -1 & -1 & -1 & -1 & -1 & -1 & 0 & 0 & -1 \\
19 & 30 & 141 & 6 & -1 & -1 & -1 & -1 & -1 & -1 & -1 & -1 & -1 & -1 & -1 & 6 & 73 & 30 & 167 & -1 & -1 & -1 & -1 & -1 & -1 & -1 & -1 & -1 & -1 & -1 & -1 & -1 & 0 & 0"
\end{bmatrix}$$

Embodiment 6.

In this Embodiment 6, a concrete example of the parity-check matrix is shown explicitly.
For example, the following check matrix $H_{CH}$ is a slight modification of the check matrix (the check matrix described in above-mentioned Embodiment 4) of a code having a coding rate of 1/2 which is used by the International Standards IEEE802.16e. In the check matrix, each numeral shows $P_{j,1}$, -1 shows a p×p zero matrix, and 0" shows a p×p matrix as shown in the following equation (5).

$$H_{CH}=\begin{bmatrix}
-1 & 94 & 73 & -1 & -1 & -1 & -1 & -1 & 55 & 83 & -1 & -1 & 0 & -1 & -1 & -1 & -1 & -1 & -1 & -1 & -1 & -1 & -1 & -1 \\
-1 & 27 & -1 & -1 & -1 & 22 & 79 & 9 & -1 & -1 & -1 & 12 & 0 & 0 & -1 & -1 & -1 & -1 & -1 & -1 & -1 & -1 & -1 & -1 \\
-1 & -1 & -1 & 24 & 22 & 81 & -1 & 33 & -1 & -1 & -1 & 0 & -1 & 0 & 0 & -1 & -1 & -1 & -1 & -1 & -1 & -1 & -1 & -1 \\
61 & -1 & 47 & -1 & -1 & -1 & -1 & -1 & 65 & 25 & -1 & -1 & -1 & -1 & 0 & 0 & -1 & -1 & -1 & -1 & -1 & -1 & -1 & -1 \\
-1 & -1 & 39 & -1 & -1 & -1 & 84 & -1 & -1 & 41 & 72 & -1 & -1 & -1 & -1 & 0 & 0 & -1 & -1 & -1 & -1 & -1 & -1 & -1 \\
-1 & -1 & -1 & -1 & 46 & 40 & -1 & 82 & -1 & -1 & -1 & 79 & -1 & -1 & -1 & -1 & 0 & 0 & -1 & -1 & -1 & -1 & -1 & -1 \\
-1 & -1 & 95 & 53 & -1 & -1 & -1 & -1 & -1 & 14 & 18 & -1 & -1 & -1 & -1 & -1 & -1 & 0 & 0 & -1 & -1 & -1 & -1 & -1 \\
-1 & 11 & 73 & -1 & -1 & -1 & 2 & -1 & -1 & 47 & -1 & -1 & -1 & -1 & -1 & -1 & -1 & -1 & 0 & 0 & -1 & -1 & -1 & -1 \\
12 & -1 & -1 & -1 & 83 & 24 & -1 & 43 & -1 & -1 & -1 & 51 & -1 & -1 & -1 & -1 & -1 & -1 & -1 & 0 & 0 & -1 & -1 & -1 \\
-1 & -1 & -1 & -1 & -1 & 94 & -1 & 59 & -1 & -1 & 70 & 72 & -1 & -1 & -1 & -1 & -1 & -1 & -1 & -1 & 0 & 0 & -1 & -1 \\
-1 & -1 & 7 & 65 & -1 & -1 & -1 & -1 & 39 & 49 & -1 & -1 & -1 & -1 & -1 & -1 & -1 & -1 & -1 & -1 & -1 & 0 & 0 & -1 \\
43 & -1 & -1 & -1 & -1 & 66 & -1 & 41 & -1 & -1 & -1 & 26 & -1 & -1 & -1 & -1 & -1 & -1 & -1 & -1 & -1 & -1 & 0 & 0"
\end{bmatrix}$$

$$I(0'')=\begin{bmatrix}
1 & & & & \\
1 & 1 & & & \\
 & \ddots & \ddots & & \\
 & & 1 & 1 & \\
 & & & 1 & 1
\end{bmatrix}\qquad\qquad(5)$$

Next, an example of an extension of this check matrix $H_{CH}$ to create a check matrix having a coding rate of 1/3 is shown. In this example, a portion designated by A and two portions designated by I are designed by using the method in accordance with the present invention.

```
-1 94 73 -1 -1 -1 -1 -1 55 83 -1 -1  0 -1 -1 -1 -1 -1 -1 -1 -1 -1 -1 | -1 -1 -1 -1 -1 -1 -1 -1 -1 -1 -1 -1
-1 27 -1 -1 -1 22 79  9 -1 -1 -1 12  0  0 -1 -1 -1 -1 -1 -1 -1 -1 -1 | -1 -1 -1 -1 -1 -1 -1 -1 -1 -1 -1 -1
-1 -1 -1 24 22 81 -1 33 -1 -1 -1  0 -1  0  0 -1 -1 -1 -1 -1 -1 -1 -1 | -1 -1 -1 -1 -1 -1 -1 -1 -1 -1 -1 -1
61 -1 47 -1 -1 -1 -1 -1 65 25 -1 -1  0  0 -1 -1 -1 -1 -1 -1 -1 -1 -1 | -1 -1 -1 -1 -1 -1 -1 -1 -1 -1 -1 -1
-1 -1 39 -1 -1 -1 84 -1 -1 -1 41 72 -1 -1 -1 -1  0  0 -1 -1 -1 -1 -1 | -1 -1 -1 -1 -1 -1 -1 -1 -1 -1 -1 -1
-1 -1 -1 -1 46 40 -1 82 -1 -1 -1 19 -1 -1 -1 -1  0  0 -1 -1 -1 -1 -1 | -1 -1 -1 -1 -1 -1  0 -1 -1 -1 -1 -1
-1 -1 95 53 -1 -1 -1 -1 -1 14 18 -1 -1 -1 -1 -1  0  0 -1 -1 -1 -1 -1 | -1 -1 -1 -1 -1 -1 -1 -1 -1 -1 -1 -1
-1 11 73 -1 -1 -1  2 -1 -1 47 -1 -1 -1 -1 -1 -1  0  0 -1 -1 -1 -1 -1 | -1 -1 -1 -1 -1 -1 -1 -1 -1 -1 -1 -1
12 -1 -1 -1 83 24 -1 43 -1 -1 -1 51 -1 -1 -1 -1 -1  0  0 -1 -1 -1 -1 | -1 -1 -1 -1 -1 -1 -1 -1 -1 -1 -1 -1
-1 -1 -1 -1 -1 94 -1 59 -1 -1 70 72 -1 -1 -1 -1 -1 -1  0  0 -1 -1 -1 | -1 -1 -1 -1 -1 -1 -1 -1 -1 -1 -1 -1
-1 -1  7 65 -1 -1 -1 -1 39 49 -1 -1 -1 -1 -1 -1 -1 -1  0  0 -1 -1 -1 | -1 -1 -1 -1 -1 -1 -1 -1 -1 -1 -1 -1
43 -1 -1 -1 -1 66 -1 41 -1 -1 -1 26 -1 -1 -1 -1 -1 -1 -1 -1  0  0 -1 | -1 -1 -1 -1 -1 -1 -1 -1 -1 -1 -1 -1
-1 -1  0 -1 -1  0 -1  0 -1 -1 -1 -1  0 -1 -1 -1 -1 -1 -1 -1 -1 -1 -1 |  0 -1 -1 -1 -1 -1 -1 -1 -1 -1 -1 -1
-1 -1 -1 -1 -1 -1 -1 -1 -1 28 -1 56 -1  0 -1 -1 -1 -1 -1 -1 -1 -1 -1 | -1  0 -1 -1 -1 -1 -1 -1 -1 -1 -1 -1
-1 -1  2 -1 -1  4 -1 10 -1 -1 -1 -1 -1 -1  0 -1 -1 -1 -1 -1 -1 -1 -1 | -1 -1  0 -1 -1 -1 -1 -1 -1 -1 -1 -1
-1 -1 -1 -1 -1 -1 -1 -1 -1 32 -1 64 -1 -1 -1  0 -1 -1 -1 -1 -1 -1 -1 | -1 -1 -1  0 -1 -1 -1 -1 -1 -1 -1 -1
-1  6 -1 -1 12 -1 36 -1 -1 -1 -1 -1 -1 -1 -1 -1  0 -1 -1 -1 -1 -1 -1 | -1 -1 -1 -1  0 -1 -1 -1 -1 -1 -1 -1
-1 -1 -1 -1 -1 -1 -1 -1 38 -1 58 -1 -1 -1 -1 -1 -1  0 -1 -1 -1 -1 -1 | -1 -1 -1 -1 -1  0 -1 -1 -1 -1 -1 -1
-1 -1 14 -1 -1 28 -1 62 -1 -1 -1 -1 -1 -1 -1 -1 -1 -1  0 -1 -1 -1 -1 | -1 -1 -1 -1 -1 -1  0 -1 -1 -1 -1 -1
-1 -1 -1 -1 -1 -1 -1 -1  0 -1 -1  0 -1 -1 -1 -1 -1 -1 -1  0 -1 -1 -1 | -1 -1 -1 -1 -1 -1 -1  0 -1 -1 -1 -1
-1 -1 16 -1 -1 32 -1 86 -1 -1 -1 -1 -1 -1 -1 -1 -1 -1 -1 -1  0 -1 -1 | -1 -1 -1 -1 -1 -1 -1 -1  0 -1 -1 -1
-1 -1 -1 -1 -1 -1 -1 -1  4 -1  8 -1 -1 -1 -1 -1 -1 -1 -1 -1 -1  0 -1 | -1 -1 -1 -1 -1 -1 -1 -1 -1  0 -1 -1
-1 -1 20 -1 -1 40 -1 78 -1 -1 -1 -1 -1 -1 -1 -1 -1 -1 -1 -1 -1 -1  0 | -1 -1 -1 -1 -1 -1 -1 -1 -1 -1  0 -1
-1 -1 -1 -1 -1 -1 -1 -1 -1 10 -1  2 -1 -1 -1 -1 -1 -1 -1 -1 -1 -1 -1  0 -1 -1 -1 -1 -1 -1 -1 -1 -1 -1 -1  0
```

Industrial Applicability

As mentioned above, according to the check matrix generation method in accordance with the present invention, a parity-check matrix having a good performance and having a regular configuration can be created. Therefore, the check matrix generation method in accordance with the present invention is suitable for use in a transmitter that encodes information bits using this parity-check matrix and transmits them, a receiver that decodes information bits by using this parity-check matrix, a communication system consisting of the transmitter and the receiver, and so on.

**Claims**

1. A check matrix creation device for creating a quasi-cyclic matrix which is a parity check matrix for an LDPC code, said check matrix creation device comprising:

   a circulant permutation matrix setting means for preparing a plurality of circulant permutation matrices; and
   a quasi-cyclic matrix creation means for arranging the plurality of circulant permutation matrices prepared by said circulant permutation matrix setting means both in a row direction and in a column direction to create a quasi-cyclic matrix.

2. The check matrix creation device according to claim 1, wherein the circulant permutation matrix setting means prepares the plurality of circulant permutation matrices each having an inner diameter of six or larger.

3. The check matrix creation device according to claim 1, wherein when arranging the plurality of circulant permutation matrices both in the row direction and in the column direction to create a quasi-cyclic matrix, the quasi-cyclic matrix creation means divides said circulant permutation matrices into parts in the column direction without changing components of the quasi-cyclic matrix connected to a specific row, and satisfies a constraint of non-occurrence of a loop in a relationship between nodes in the column direction and nodes in the row direction of the quasi-cyclic matrix after the division is done.

4. The check matrix creation device according to claim 1, wherein when arranging the plurality of circulant permutation matrices both in the row direction and in the column direction to create the quasi-cyclic matrix, the quasi-cyclic matrix creation means divides said circulant permutation matrices into parts in the row direction without changing components of the quasi-cyclic matrix connected to a specific row, and satisfies a constraint of non-occurrence of a loop in a relationship between nodes in the row direction and nodes in the column direction of the quasi-cyclic matrix after the division is done.

5. The check matrix creation device according to claim 3, wherein when the quasi-cyclic matrix is represented by a bipartite graph and each of the plurality of circulant permutation matrices is a matrix of p rows and p columns, the quasi-cyclic matrix creation means connects between nodes of two subgraphs by using p branches.

**6.** The check matrix creation device according to claim 3, wherein when the quasi-cyclic matrix is represented by a bipartite graph and each of the plurality of circulant permutation matrices is a matrix of p rows and p columns, the quasi-cyclic matrix creation means connects between nodes of two subgraphs by using 2*p or more branches and satisfies a constraint of non-occurrence of a loop between nodes connected using 2*p or more branches.

**7.** The check matrix creation device according to claim 1, wherein when preparing the plurality of circulant permutation matrices, the circulant permutation matrix setting means prepares, as a part of the circulant permutation matrices, a circulant permutation matrix I(0") as shown below.

$$I(0'') = \begin{bmatrix} 1 & & & & \\ 1 & 1 & & & \\ & \ddots & \ddots & & \\ & & 1 & 1 & \\ & & & 1 & 1 \end{bmatrix}$$

**8.** The check matrix creation device according to claim 1, wherein when preparing the plurality of circulant permutation matrices, the circulant permutation matrix setting means prepares, as a part of the circulant permutation matrices, a stair-like submatrix, as shown below, which is a combination of circulant permutation matrices I(0) and I(0").

$$\begin{bmatrix} I(0) & & & & \\ I(0) & I(0) & & & \\ & \ddots & & \ddots & \\ & & I(0) & I(0) & \\ & & & I(0) & I(0'') \end{bmatrix}$$

where

$$I(0) = \begin{bmatrix} 1 & 0 & 0 & \cdots & 0 \\ 0 & 1 & \ddots & \ddots & \vdots \\ \vdots & \ddots & \ddots & \ddots & \vdots \\ 0 & \ddots & \ddots & 1 & 0 \\ 0 & \cdots & \cdots & 0 & 1 \end{bmatrix} \quad , \quad I(0'') = \begin{bmatrix} 1 & & & & \\ 1 & 1 & & & \\ & \ddots & \ddots & & \\ & & 1 & 1 & \\ & & & 1 & 1 \end{bmatrix}$$

**9.** The check matrix creation device according to claim 1, wherein when preparing the plurality of circulant permutation matrices, the circulant permutation matrix setting means prepares circulant permutation matrices having different column weights and different inner diameters.

**10.** A check matrix creation method of creating a quasi-cyclic matrix which is a parity-check matrix for an LDPC code, said check matrix creation method comprising:

a circulant permutation matrix setting step of a circulant permutation matrix setting means preparing a plurality of circulant permutation matrices each having an inner diameter of six or larger; and
a quasi-cyclic matrix creating step of a quasi-cyclic matrix creation means arranging the plurality of circulant permutation matrices prepared by said circulant permutation matrix setting means both in a row direction and in a column direction to create a quasi-cyclic matrix.

**11.** A check matrix creation program for creating a quasi-cyclic matrix which is a parity-check matrix for an LDPC code, said check matrix creation program causing a computer to carry out:

a circulant permutation matrix setting process of a circulant permutation matrix setting means preparing a plurality of circulant permutation matrices each having an inner diameter of six or larger; and
a quasi-cyclic matrix creating process of a quasi-cyclic matrix creation means arranging the plurality of circulant permutation matrices prepared by said circulant permutation matrix setting means both in a row direction and in a column direction to create a quasi-cyclic matrix.

**12.** A transmitter comprising:

a circulant permutation matrix setting means for preparing a plurality of circulant permutation matrices each having an inner diameter of six or larger;
a quasi-cyclic matrix creation means for arranging the plurality of circulant permutation matrices prepared by said circulant permutation matrix setting means both in a row direction and in a column direction to create a quasi-cyclic matrix which is a parity-check matrix for an LDPC code;
a codeword creation means for creating a codeword from predetermined information bits and the quasi-cyclic matrix created by said quasi-cyclic matrix creation means; and
a transmitting means for modulating the codeword created by said codeword creation means and transmitting a modulated signal of said codeword.

**13.** A receiver comprising:

a circulant permutation matrix setting means for preparing a plurality of circulant permutation matrices each having an inner diameter of six or larger;
a quasi-cyclic matrix creation means for arranging the plurality of circulant permutation matrices prepared by said circulant permutation matrix setting means both in a row direction and in a column direction to create a quasi-cyclic matrix which is a parity-check matrix for an LDPC code;
a receiving means for receiving the modulated signal to demodulate this modulated signal; and
a decoding means for decoding a demodulated result obtained by said receiving means to generate information bits by using the quasi-cyclic matrix created by said quasi-cyclic matrix creation means.

**14.** A communication system provided with a transmitter that creates a codeword from predetermined information bits and a parity-check matrix for an LDPC code, modulates said codeword, and transmits a modulated signal of said codeword, and a receiver that receives and demodulates the modulated signal of the codeword transmitted from said transmitter, and decodes a demodulated result of said modulated signal to generate said information bits by using said quasi-cyclic matrix, wherein
each of said transmitter and said receiver comprises a check matrix creation device for creating a quasi-cyclic matrix which is a parity-check matrix for an LDPC code, and said check matrix creation device is comprised of:

a circulant permutation matrix setting means for preparing a plurality of circulant permutation matrices each having an inner diameter of six or larger; and
a quasi-cyclic matrix creation means for arranging the plurality of circulant permutation matrices prepared by said circulant permutation matrix setting means both in a row direction and in a column direction to create a quasi-cyclic matrix which is a parity-check matrix for an LDPC code.

# FIG.1

**Transmitter** ~1

Check Matrix Creation Device ~11

Circulant Permutation Matrix Setting Unit ~12

Quasi-Cyclic Matrix Creation Unit ~13

$H_M$

14

LDPC Encoder

$(u_1, u_2, ..., u_K)$ Message

$(v_1, v_2, ..., v_N)$ Codeword

15

Modulator

$(x_1, x_2, ..., x_N)$

Communication Channel ~2

**Receiver** ~3

$(u_1, u_2, ..., u_K)$ Estimation Result

LDPC Decoder

$H_M$  25

Demodulator

24

$(y_1, y_2, ..., y_N)$

Circulant Permutation Matrix Setting Unit ~23

Quasi-Cyclic Matrix Creation Unit ~22

Check Matrix Creation Device ~21

EP 2 306 653 A1

# FIG.2

```
                    ┌──────────┐
                    │  Start   │
                    └──────────┘
                         │
                         ▼
┌────────────────────────────────────────────────────┐
│ Prepare a Plurality of Circulant Permutation Matrices│ ~ST1
│   Each Having an Inner Diameter G of Six or Larger   │
└────────────────────────────────────────────────────┘
                         │
                         ▼
┌────────────────────────────────────────────────────┐
│ Arrange the Plurality of Circulant Permutation Matrices│ ~ST2
│ Both in the Row Direction and in the Column Direction  │
│          to Create a Parity-Check Matrix             │
└────────────────────────────────────────────────────┘
                         │
                         ▼
                    ┌──────────┐
                    │   End    │
                    └──────────┘
```

# FIG.3

# FIG.4

Five Branches

$V_0$ $C_0$
$V_1$ $C_1$
$V_2$

# FIG.5

$V_0$ $C_0$
$V_1$ $C_1$
$V_2$ $C_2$
$V_3$

# FIG.6

$C_0$
$V_0$ $C_1$
$C_2$

# FIG.7

$V_{0\_0}$ $C_0$
$V_{0\_1}$ $C_1$
$V_{0\_2}$ $C_2$

# FIG.8

# FIG.9

# FIG.10

# FIG.11

# FIG.12

Mobile Terminal 100

Information Data

| Physical Layer LDPC Encoder | 101 |

| Modulator | 102 |

| Demodulator | 103 |

| Physical Layer LDPC Decoder | 104 |

Decoded Data

105

205

200  Base Station

Decoded Data → Network

| Physical Layer LDPC Decoder | 204 |

| Demodulator | 203 |

| Modulator | 202 |

| Physical Layer LDPC Encoder | 201 |

Information Data ← Network

# FIG.13

**Mobile Terminal** 300

Information Data

301
Upper Hierarchical Layer LDPC Encoder

302
Physical Layer Transmitter

305

303
Physical Layer Receiver

304
Upper Hierarchical Layer LDPC Decoder

Decoded Data

400 **Base Station**

Decoded Data → Network

404
Upper Hierarchical Layer LDPC Decoder

405

403
Physical Layer Receiver

402
Physical Layer Transmitter

401
Upper Hierarchical Layer LDPC Encoder

Information Data ← Network

# FIG.14

EP 2 306 653 A1

# FIG.15

$$H = \begin{bmatrix} 1 & 1 & 0 \\ 1 & 1 & 1 \end{bmatrix} \implies$$

<table>
<tr><td colspan="2" align="center">**INTERNATIONAL SEARCH REPORT**</td><td>International application No.<br>PCT/JP2009/002955</td></tr>
</table>

**A.  CLASSIFICATION OF SUBJECT MATTER**
*H03M13/19(2006.01)i*

According to International Patent Classification (IPC) or to both national classification and IPC

**B.  FIELDS SEARCHED**

Minimum documentation searched (classification system followed by classification symbols)
H03M13/19

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| X | Xiaofu Wu et al., A Necessary and Sufficient Condition for Determining the Girth of Quasi-Cyclic LDPC Codes, IEEE Transactions on Communications, Vol.56, No.6, June 2008, pp.854-857 | 1,2,10-14 |
| X | WO 2007/088870 A1  (Mitsubishi Electric Corp.), 09 August, 2007 (09.08.07), Par. Nos. [0002] to [0014] & US 2009/0063930 A1 | 1,2,10-14 |
| A | Masaya Fujisawa et al., A Class of Quasi-Cyclic Regular LDPC Codes from Cyclic Difference Families with Girth 8, Proceedings of the International Symposium on Information Theory, 2005. (ISIT 2005), 4-9 September, 2005, pp.2290-2294 | 1-14 |

☒  Further documents are listed in the continuation of Box C.          ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>13 July, 2009 (13.07.09) | Date of mailing of the international search report<br>21 July, 2009 (21.07.09) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2009/002955

C (Continuation).    DOCUMENTS CONSIDERED TO BE RELEVANT

| Category* | Citation of document, with indication, where appropriate, of the relevant passages | Relevant to claim No. |
|---|---|---|
| A | Sunghwan Kim et al., Quasi-Cyclic Low-Density Parity-Check Codes With Girth Larger Than 12, IEEE Transactions on Information Theory, Vol.53, No.8, August 2007, pp.2885-2891 | 1-14 |
| A | JP 2007-166605 A  (Samsung Electronics Co., Ltd.), 28 June, 2007 (28.06.07), Par. No. [0031]; Fig. 3 & US 2007/0162821 A1    & EP 1798861 A1 & DE 602006003516 D    & KR 2007-0063851 A & CN 1983822 A | 1-14 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. Fossorier.** Quai-Cyclic Low-Density Parity-Check Codes From Circulant Permutation Matrices. *IEEE Trans. Inform. Theory,* 2004, vol. 50 (8), 1788-1793